Europäisches Patentamt

European Patent Office

Office européen des brevets

(11) Publication number: **0 190 645**
**A2**

(12) **EUROPEAN PATENT APPLICATION**

(21) Application number: **86101101.3**

(22) Date of filing: **28.01.86**

(51) Int. Cl.⁴: **G 01 R 13/02**
**G 01 R 19/165**

(30) Priority: **07.02.85 JP 23179/85**

(43) Date of publication of application:
**13.08.86 Bulletin 86/33**

(84) Designated Contracting States:
**BE DE FR GB IT NL**

(71) Applicant: **HORIBA, LTD.**
**2 Miyanohigashi-machi Kissyoin**
**Minami-ku Kyoto(JP)**

(72) Inventor: **Yada, Takaaki**
**90, Hiramachi Nishinokyo**
**Nakagyo-ku Kyoto(JP)**

(72) Inventor: **Nakamura, Tadao**
**40, Ansyudounogo-cho Yamashima-ku**
**Kyoto(JP)**

(72) Inventor: **Asano, Ichiro**
**330-470, Bodaiji Kousei-cho**
**Kouka-gun Shiga-prefecture(JP)**

(74) Representative: **Patentanwälte TER MEER - MÜLLER -**
**STEINMEISTER**
**Mauerkircherstrasse 45**
**D-8000 München 80(DE)**

(54) **Auxiliary displaying device for a digital meter.**

(57) The changing state of a numerical value of an analog input (AS) displayed on a (digital) numeral-display can be grasped more reliable at a glance by providing a change-display (2,HK₁) in the vicinity of said numeral-display (1) for displaying the increasing and decreasing states of said analog input (AS).

Fig.2

**0190645**

# TER MEER·MÜLLER·STEINMEISTER

## PATENTANWÄLTE - EUROPEAN PATENT ATTORNEYS

Dipl.-Chem. Dr. N. ter Meer
Dipl. Ing. F. E. Müller
Mauerkircherstrasse 45
D-8000 MÜNCHEN 80

Dipl. Ing. H. Steinmeister
Artur-Ladebeck-Strasse 51
D-4800 BIELEFELD 1

HO-202
Mü/b

HORIBA, LTD.

2 Miyanohigashi-machi,

Kissyoin, Minami-ku,

Kyoto / Japan

---

## AUXILIARY DISPLAYING DEVICE FOR A DIGITAL METER

---

Priority Claimed: February 7, 1985, Japan, Ser.No. 60-23179/85

The present invention relates to an auxiliary displaying device by which the change of the display value of a digital meter can be grasped at a glance.

Digital meters are widely used in instruments, meters and the like. But with meters of this kind, since the numerals displayed are changing one after another with the change of input values, it is frequently difficult to discriminate at a glance whether the numerals change in an increasing direction or a decreasing direction.

With an attempt to avoid this problem of visible recognition, a "D + A" method is known in which an analog meter is provided together with a digital meter and the increasing or decreasing states are intended to be grasped by means of the analog meter. However, since for the above described "D + A" method a digital meter and an analog meter are provided side by side, the necessary displaying space becomes large, and also the associated circuit arrangement becomes more complicate in construction and more expensive.

The present invention was achieved in view of the above described matters and aims at the provision of an auxiliary displaying device which is simple in construction, inexpensive, and can eliminate the above outlined problem of rapid recognition of changing values displayed on a digital meter.

To this end, according to the present invention, the increasing state or the decreasing states of an analog input are displayed in a change-display provided in the vicinity of a numeral-display on the basis of a change of the analog input which was previously detected.

Due to the invention, the changing state of numerals displayed on the numeral-display can be grasped at a glance. And, since the change of an analog input in detected, the circuit is simple in construction whereby a display device of this type becomes inexpensive.

Embodiments of the invention and advantageous features thereof are illustrated by the attached drawings, in which
    Fig. 1 is a plan view showing a numeral- display and
          a change-display; and
   Figs. 2 to  5 depict various circuit diagrams
          respectively showing examples for the
          construction of a change-detecting circuit
          according to the invention.

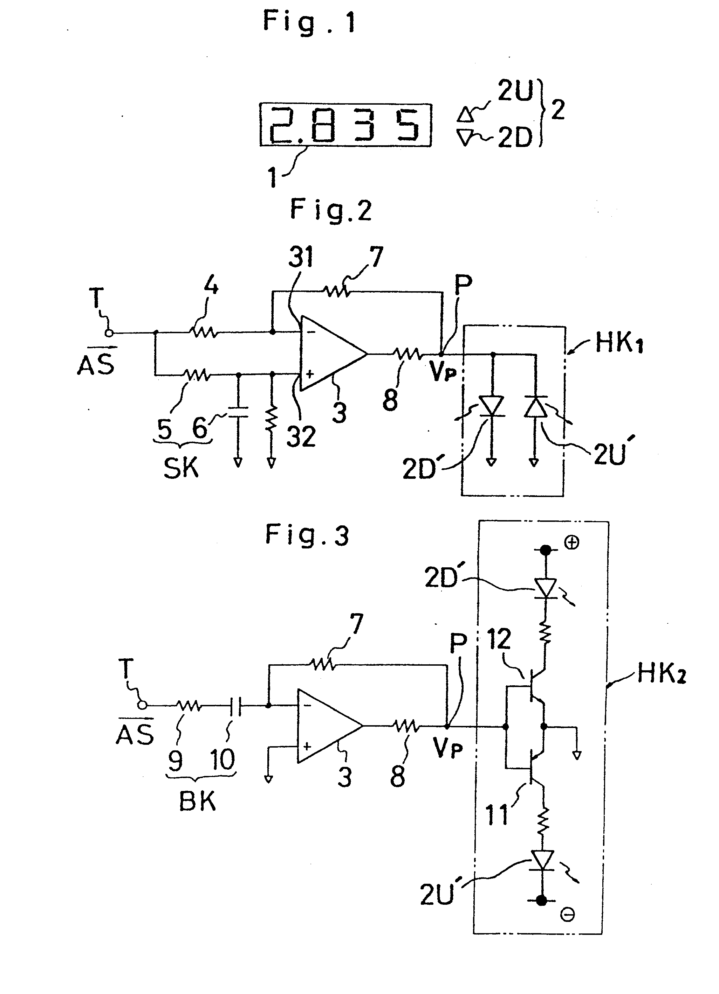

A first embodiment of the present invention is below described with reference to Figs. 1 and 2.

In Fig. 1 showing a displaying portion, 1 designates a numeral-display for displaying an analog input in the form of a digital value, the numerals (0 to 9) of each figure being displayed for example by activating respective segments of a seven segments light-emitting diodes (LEDs) display unit. A state-display 2 is provided in the vicinity of said numeral-display 1 and comprises displays 2U, 2D having a triangular plan cross section arranged with the summits thereof opposite to each other. Said displays 2U, 2D may comprise a LED as well.

Fig. 2 shows one example of a change-detecting circuit for detecting the change of an analog input and lighting, according to the detection result, either of said displays 2U, 2D. In this circuit a difference between an instantaneous value and an integrated value of the analog input is amplified by an operational amplifier 3 and one of the displays 2U, 2D is lighted depending upon the polarity of an output voltage of the operational amplifier 3.

As shown in Fig. 2 the operational amplifier 3 has one first input 31 connected to a signal input terminal T through an input resistor 4 whereby an instantaneous value of an analog input AS at the signal input terminal T is directly supplied to said input 31. On the other hand, a second input 32 of the operational amplifier 3 is connected to said signal input terminal T through an integrating circuit SK consisting of a resistor 5 and a capacitor 6 whereby the integrated value of said analog input AS is supplied to said second input 32 delayed by a time constant determined by said resistor 5 and said capacitor 6. Reference numerals 7 and 8 designate a feed-back resistor and an output resistor, respectively. A displaying circuit $HK_1$ is connected to an output P of the operational amplifier 3. Said displaying circuit $HK_1$ comprises LEDs 2U', 2D' which are the luminous elements of said display 2U, 2D, connected anti-parallel to each other.

With the change-detecting circuit constructed in the above described manner, an electric potential $V_p$ of the output P of the operational amplifier 3 is zero when the analog input AS is stabilized. However, the electric potential $V_p$ is changed to minus with an increase (change to plus) of the analog input AS while said electric potential $V_p$ is changed to plus with a decrease (change to minus) of the analog input AS. And, during this changing time, if the electric potential $V_p$ reaches or exceeds the forward voltage of the LED 2U', 2D', the LED 2U' or 2D' is activated whereby one LED 2U' (2D') is lighted. That is to say, the LED 2U' emits light when the analog input AS is increasing while the LED 2D' emits light when the analog input AS is decreasing whereby one of the displays 2U or 2D of Fig. 1 is lighted.

Figs. 3 to 5 show other embodiments of the present invention.

Fig. 3 depicts the construction of a circuit for increasing light emitting efficiency by the LED 2U', 2D'. BK designates a differentiating circuit consisting of a resistor 9 and a condenser 10, and $HK_2$ refers to a switching and display circuit consisting of a P-type transistor 11, a N-type transistor 12 and the LED 2U', 2D'. The ON-OFF control is carried out by a voltage between the bases and the emitters of the transistors 11, 12.

In addition, the integrating circuit SK of Fig. 2 may be used in place of the differentiatingcircuit BK of Fig. 3.

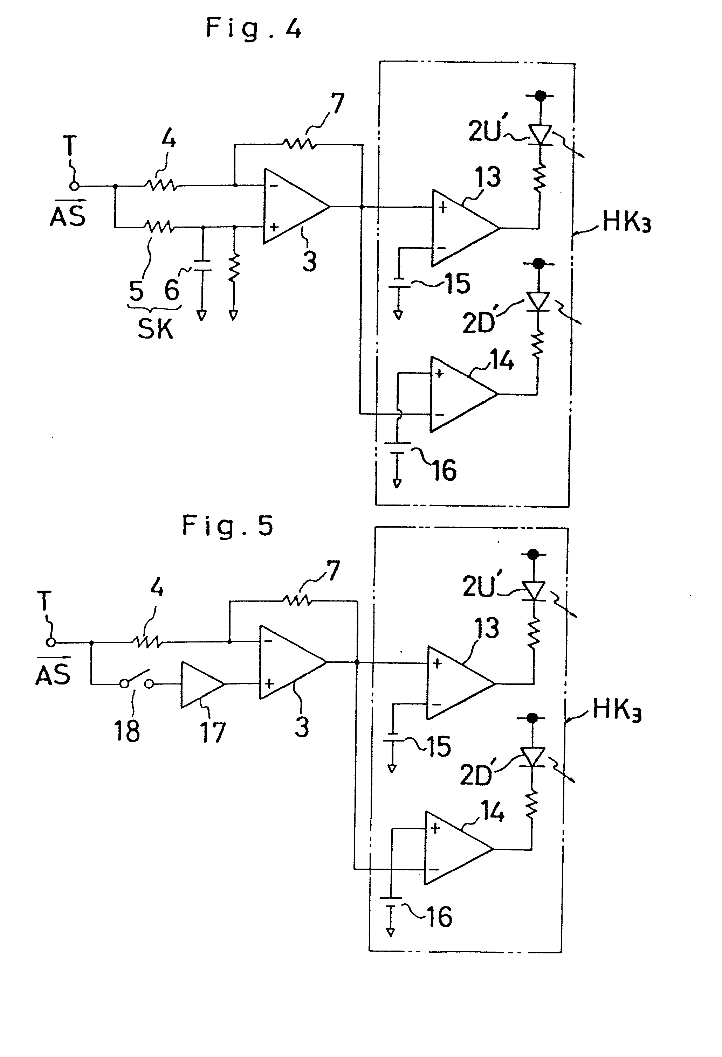

In Fig. 4 the circuit portion $HK_1$ of Fig. 2 is replaced by a display circuit $HK_3$ with comparators 13, 14 and reference potential power sources 15, 16.

In Fig. 5 a holding amplifier 17 is provided at the second input 32 of the operational amplifier 3 to compare the value of the analog input AS of an immediately preceeding holding period defined by a momentaneous closing of a switch 18 with a present instantaneous value of the analog input AS.

The shape of the change-display 2 is not limited to the one shown in Fig. 1. For example, a pair of oppositely directing arrows may be arranged side by side or one above the other. Every arrangement of pairs of display elements capable of indicating two directions may be used.

CLAIMS:

1.    An auxiliary displaying device for a digital meter, characterized by
- a circuit (3 to 7 ;9,10;17,18,31,32) for detecting a change of an anlog input (AS) and
- a change-display unit (2;HK$_1$;HK$_2$;HK$_3$) provided in the vicinity of the numeral display (1) of said digital meter for displaying the increasing and decreasing conditions of said analog input (AS) on the basis of the detected change.

2.    The auxiliary displaying device as set forth in claim 1, characterized in that the change of said analog input (AS) is detected by a comparator (3) comparing an instantaneous value of the analog input (AS) with an integrated value of said analog input (AS).

3.    The auxiliary displaying device as set forth in claim 1, characterized in that the change of said analog input (AS) is detected on the basis of a differentiating value of said analog input (AS).

4.    The auxiliary displaying device as set forth in claim 1, characterized in that the change of said analog input (AS) is detected by a comparator (3) comparing a value of the analog input hold during a preceeding sampling period with an instantaneous value of the analog input (AS).

## Fig.1

2.835   △ 2U ⎫
        ▽ 2D ⎭ 2

1

## Fig.2

T
$\overline{AS}$

4

31    7    P

HK₁

3
8    Vₚ

5  6
SK

32

2D′        2U′

## Fig.3

7

T
$\overline{AS}$

P  12

HK₂

3    8    Vₚ

9   10
BK

11

2D′   ⊕

2U′   ⊖

Fig.4

Fig.5